(19) Europäisches Patentamt
European Patent Office
Office européen des brevets

(11) Veröffentlichungsnummer: **0 451 561 B1**

(12) **EUROPÄISCHE PATENTSCHRIFT**

(45) Veröffentlichungstag der Patentschrift: **09.11.94**

(51) Int. Cl.[5]: **C08F 2/50**, G03F 7/031, B41M 5/30

(21) Anmeldenummer: **91104295.0**

(22) Anmeldetag: **20.03.91**

# (54) Photopolymerisierbares Gemisch und daraus hergestelltes Aufzeichnungsmaterial.

(30) Priorität: **27.03.90 DE 4009700**

(43) Veröffentlichungstag der Anmeldung:
**16.10.91 Patentblatt 91/42**

(45) Bekanntmachung des Hinweises auf die Patenterteilung:
**09.11.94 Patentblatt 94/45**

(84) Benannte Vertragsstaaten:
**CH DE FR GB IT LI NL**

(56) Entgegenhaltungen:
**EP-A- 0 138 187**
**DE-A- 3 019 211**
**US-A- 3 728 115**
**US-A- 3 888 672**

**DIE MAKROMOLEKULAIRE CHEMIE, Band 161, 1972, Seiten 241-250; T. NAKAYA et al.: "Vinyl polymerization 288. Polymerization of vinyl monomers photosensitized by 3-acetoxy-3.5.5.-trimethyl-1-pyrazoline"**

(73) Patentinhaber: **MORTON INTERNATIONAL, INC.**
**100 North Riverside Plaza,**
**Randolph Street at the River**
**Chicago, Illinois 60606 (US)**

(72) Erfinder: **Lingnau, Jürgen, Dr.**
**Karolingerstrasse 10**
**W-6500 Mainz-Laubenheim (DE)**
Erfinder: **Frommeld, Hans-Dieter, Dr.**
**Simrockstrasse 7A**
**W-6200 Wiesbaden (DE)**

(74) Vertreter: **Weber, Dieter, Dr. et al**
**Weber, Dieter, Dr.,**
**Seiffert, Klaus, Dipl.-Phys.,**
**Lieke, Winfried, Dr.**
**Postfach 61 45**
**D-65051 Wiesbaden (DE)**

**EP 0 451 561 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein photopolymerisierbares Gemisch, das ein polymeres Bindemittel, eine polymerisierbare Verbindung mit mindestens einer endständigen ethylenischen Doppelbindung und einem Siedepunkt oberhalb 100 °C bei Normaldruck und eine Photoinitiatorkombination enthält und das zur Herstellung von Aufzeichnungsmaterialien, insbesondere von Druckplatten und Photoresists geeignet ist.

Aus der EP-A 138 187 sind photopolymerisierbare Gemische bekannt, die als Photoinitiatoren eine Kombination eines Hexaarylbisimidazols mit einem mit p-Dialkylamino-phenylgruppen substituierten N-Heterocyclus enthalten. Diese substituierten N-Heterocyclen haben den Nachteil, daß sie in Säuren gut löslich sind und z. B. bei der Anwendung als Galvanoresist von den sauren Bädern extrahiert werden und diese verunreinigen.

In der JP-A 55/75 405 werden Derivate des 2-Pyrazolins mit Substituenten in 1-, 3-, 4- und/oder 5-Stellung als Photoinitiatoren beschrieben, die ggf. mit Verbindungen mit aromatischen Ketogruppen kombiniert werden. Diese Initiatoren und Initiatorkombinationen ergeben Gemische, die für die Praxis nicht ausreichend lichtempfindlich sind.

Aus der DE-A 30 19 211 ist es bekannt, als Photoinitiatoren wirkende Jodonium- und Sulfoniumverbindungen mit Polyarylpyrazolinen zu sensibilisieren und diese Gemische mit radikalisch polymerisierbaren Monomeren zu kombinieren. Die Lichtempfindlichkeit dieser Gemische ist ebenfalls nicht ausreichend.

Aufgabe der Erfindung war es photopolymerisierbare Gemische zur Verfügung zu stellen, die eine hohe Lichtempfindlichkeit und gute Bildwiedergabe aufweisen und die keine Bestandteile enthalten, die in nennenswertem Maße durch saure Verarbeitungsbäder aus der lichtgehärteten Schicht herausgelöst werden.

Gegenstand der Erfindung ist ein photopolymerisierbares Gemisch, das als wesentliche Bestandteile

a) ein polymeres Bindemittel,

b) eine polymerisierbare Verbindung mit mindestens einer endständigen ethylenischen Doppelbindung und einem Siedepunkt oberhalb 100 °C bei Normaldruck,

c) ein Hexaarylbisimidazol und

d) einen weiteren Photoinitiator

enthält.

Das erfindungsgemäße Gemisch ist dadurch gekennzeichnet, daß der weitere Photoinitiator ein 1,3-Diaryl- oder ein 1-Aryl-3-aralkenyl-pyrazolin ist.

Die in dem erfindungsgemäßen Gemisch eingesetzten Pyrazoline haben vorzugsweise die allgemeine Formel I

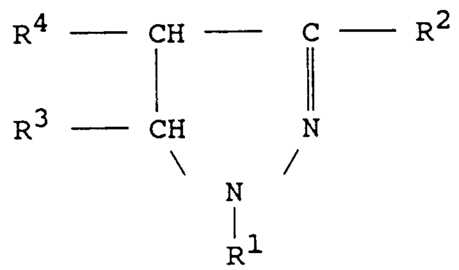

worin

$R^1$ ein substituierter oder unsubstituierter 1- bis 3-kerniger Arylrest, vorzugsweise ein ggf. substituierter Phenylrest,

$R^2$ ein Rest der Bedeutung von $R^1$ oder ein ggf. substituierter Aralkenylrest, insbesondere ein ggf. substituierter Styrylrest,

$R^3$ ein Wasserstoffatom, ein Alkylrest, vorzugsweise mit 1 bis 6 Kohlenstoffatomen oder, bevorzugt, ein Rest der Bedeutung von $R^1$,

$R^4$ ein Wasserstoffatom oder ein Alkylrest, insbesondere mit 1 bis 4 Kohlenstoffatomen, vorzugsweise ein Wasserstoffatom,

ist. Als Substituenten in den Resten $R^1$ und $R^2$ kommen niedere Alkylgruppen, Halogenatome, $R^4O$, $R^4S$, CN, Acylamino-, Aryl- und Acyloxygruppen in Betracht. Bevorzugt werden Alkyl- oder Alkoxygruppen mit 1 bis 4 Kohlenstoffatomen, insbesondere Methyl- oder Methoxygruppen, oder Chloratome.

Das Pyrazolin wird, bezogen auf die Menge an polymerisierbaren Verbindungen in einer bevorzugte Menge von 0,01 bis 10 %, besonders bevorzugt 0,1 bis 1 %, zugesetzt. Beispiele für geeignete Verbindungen der Formel I sind:

1,3-Diphenyl-2-pyrazolin,
1-p-Methoxyphenyl-3-phenyl-2-pyrazolin,
1-Phenyl-3-p-cyanophenyl-2-pyrazolin,
1-Phenyl-3-styryl-2-pyrazolin,
1-Naphthyl-3-phenyl-2-pyrazolin,
1-p-Chlorphenyl-3-phenyl-2-pyrazolin,
1-m-Chlorphenyl-3-(2,4-dimethoxyphenyl)-2-pyrazolin,
1-(3,4-Dichlorphenyl)-3-phenyl-2-pyrazolin,
1-p-Methylsulfonylphenyl-3-phenyl-2-pyrazolin,
1-p-Acetylaminophenyl-3-phenyl-2-pyrazolin,
5-Isopropyl-1,3-diphenyl-2-pyrazolin,
1-p-Tolyl-3-phenyl-2-pyrazolin,
1-p-Methoxycarbonylphenyl-3-phenyl-2-pyrazolin,
1,3-Diphenyl-5-p-acetylaminophenyl-2-pyrazolin,
1,3,5-Triphenyl-2-pyrazolin,
1,5-Diphenyl-3-styryl-2-pyrazolin,
1-Phenyl-3-(p-methoxystyryl)-5-(p-methoxyphenyl)-2-pyrazolin,
1-Phenyl-3-(2,4-dichlorstyryl)-5-(2,4-dichlorphenyl)-2-pyrazolin,
1-(p-Methoxyphenyl)-3-(o-chlorstyryl)-5-phenyl-2-pyrazolin,
1-p-Biphenylyl-3,5-diphenyl-2-pyrazolin,
1-Phenyl-3-(2-naphthyl)-5-p-biphenylyl-2-pyrazolin,
1,3-Diphenyl-5-(9-anthryl)-2-pyrazolin,
1-Phenyl-3-p-biphenylyl-5-(2-isopropylphenyl)-2-pyrazolin,
1,3-Diphenyl-5-naphthyl-2-pyrazolin,

Die Herstellung der Verbindungen ist bekannt und z. B. bei A. Wagner et al, Angew. Chem., Int. Ed., Bd. 5, S. 699 (1966); R. H. Wiley et al, J. Org. Chem., Bd. 23, S. 732 (1958) und H. A. Evans et al, Aust. J. Chem., Bd. 27, S. 2267 (1974) beschrieben.

Geeignete Hexaarylbisimidazole sind Dimere des 2,4,5-Triarylimidazols, die über eine kovalente Bindung verbunden sind:

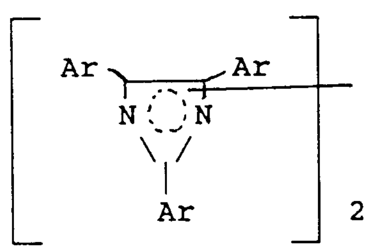

Die Arylreste sind bevorzugt Phenylreste, die durch Halogenatome, wie Chlor, Fluor oder Brom, Alkylgruppen oder Alkoxygruppen substituiert sein können. Die Arylgruppen in 4- und 5-Position können auch miteinander verbunden sein. Geeignete Verbindungen dieses Typs sind Z. B. in den US-A 3 479 185 und 3 888 672 und der EP-A 138 187 beschrieben.

Für die Zwecke der Erfindung geeignete polymerisierbare Verbindungen sind bekannt und z. B. in den US-A 2 760 863 und 3 060 023 beschrieben.

Bevorzugte Beispiele sind Acryl- und Methacrylsäureester von ein- oder bevorzugt mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen oder N-substituierte Acryl- und Methacrylsäureamide. Mit Vorteil werden auch Umsetzungsprodukte von Mono- oder Diisocyanaten mit Partialestern mehrwertiger Alkohole eingesetzt. Derartige Monomere sind in den DE-A 20 64 079, 23 61 041 und 28 22 190 beschrieben.

Der Mengenanteil an Monomeren beträgt im allgemeinen etwa 10 bis 80, vorzugsweise 20 bis 60 Gew.-%, bezogen auf die Gesamtmenge an Monomeren und Bindemittel.

Als Bindemittel kann eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Mit besonderem Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrig-alkalischen Entwicklern entwickeln lassen. Derartige Bindemittel können z. B. die folgenden Gruppen enthalten:
$-COOH$, $-PO_3H_2$, $-SO_3H$; $-SO_2NH-$, $-SO_2-NH-SO_2-$ und $-SO_2-NH-CO-$.

Als Beispiele hierfür seien genannt: Maleinatharze, Polymerisate aus N-(p-Tolyl-sulfonyl)-carbaminsäure-$\beta$-(methacryloyloxy)-ethylester und Mischpolymerisate dieser und ähnlicher Monomerer mit anderen Monomeren sowie Vinylacetat/Crotonsäure-und Styrol/Maleinsäureanhydrid-Mischpolymerisate. Alkyl(meth)-acrylat/Methacrylsäure-Mischpolymerisate und Mischpolymerisate aus Methacrylsäure, höheren Alkyl-(meth)acrylaten und Methylmethacrylat und/oder Styrol, Acrylnitril u. a., wie sie in den DE-A 20 64 080 und 23 63 806 beschrieben sind, werden bevorzugt.

Die Menge des Bindemittels beträgt im allgemeinen 20 bis 90, vorzugsweise 40 bis 80 Gew.-%, bezogen auf die Menge an Monomerem und Bindemittel.

Die photopolymerisierbaren Gemische können je nach geplanter Anwendung und je nach den gewünschten Eigenschaften verschiedenartige Stoffe als Zusätze enthalten. Beispiele sind:
Haftvermittler, Inhibitoren zur Verhinderung der thermischen Polymerisation der Monomeren, Wasserstoffdonatoren, die sensitometrischen Eigenschaften derartiger Schichten modifizierende Stoffe, Farbstoffe, gefärbte und ungefärbte Pigmente, Farbbildner, Leukofarbstoffe, Indikatorfarbstoffe und Weichmacher, z. B. Polyglykole oder Ester der p-Hydroxybenzoesäure.

Beispiele für geeignete Zusätze sind Schwefelverbindungen, wie Mercaptobenzimidazol, Mercaptobenzthiazol, Imidazol oder Imidazolderivate, Halogenverbindungen, wie 2-Methyl-4,6-bis-trichlormethyl-s-triazin, [2-(4-Styryl-phenyl)-]4,6-bis-trichlormethyl-s-triazin oder 2-Trichlormethyl-5-styryl-1,3,4-oxdiazol, Verbindungen mit dreiwertigem Phosphor wie Triphenylphosphin oder Triphenylphosphit.

Diese Bestandteile sind zweckmäßig so auszuwählen, daß sie in dem für den Initiierungsvorgang wichtigen aktinischen Strahlungsbereich möglichst wenig absorbieren.

Das photopolymerisierbare Gemisch kann für die verschiedensten Anwendungen Einsatz finden, beispielsweise zur Herstellung von Lacken, die durch Licht gehärtet werden, und insbesondere als lichtempfindliches Aufzeichnungsmaterial auf dem Reproduktionsgebiet.

Die detaillierte Beschreibung der Erfindung beschränkt sich auf dieses Anwendungsgebiet, jedoch ist die Erfindung nicht hierauf beschränkt. Als Anwendungsmöglichkeiten auf diesem Gebiet seien genannt:
Aufzeichnungsschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, verwendbar. Besondere Bedeutung haben die erfindungs-gemäßen Gemische für die Photoresisttechnik, insbesondere als Trockenphotoresistmaterialien.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl. aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckformen, vorliegen. Ebenso ist es für die Herstellung von Trockenresist geeignet.

Als Schichtträger für mit dem erfindungsgemäßen Gemisch hergestellte Kopiermaterialien sind beispielsweise Aluminium, Stahl, Zink, Kupfer und Kunststoff-Folien, z. B. aus Polyethylenterephthalat oder Celluloseacetat, sowie Siebdruckträger, wie Perlongaze, geeignet.

Die Herstellung der lichtempfindlichen Materialien unter Verwendung des erfindungsgemäßen Gemischs erfolgt in bekannter Weise.

So kann man dieses in einem Lösungsmittel aufnehmen und die Lösung bzw. Dispersion durch Gießen, Sprühen, Tauchen, Antrag mit Walzen usw. auf den vorgesehenen Träger als Film antragen und anschließend trocknen. Dicke Schichten (z. B. von 250 µm und darüber) werden vorteilhaft durch Extrudieren oder Verpressen als selbsttragende Folie hergestellt, welche dann ggf. auf den Träger laminiert wird. Im Falle von Trockenresist werden Lösungen des Gemischs auf transparente Träger aufgebracht und angetrocknet.

Die lichtempfindlichen Schichten - Dicke etwa zwischen 10 und 100 µm - werden dann gleichfalls zunächst zusammen mit dem temporären Träger auf das gewünschte Substrat auflaminiert.

Die Verarbeitung der Materialien wird in bekannter Weise vorgenommen. Die Bebilderung erfolgt durch Belichten mit aktinischer Strahlung. Als aktinische Strahlung soll im Rahmen dieser Beschreibung jede Strahlung verstanden werden, deren Energie mindestens der des kurzwelligen sichtbaren Lichts entspricht. Geeignet ist langwellige UV-Strahlung, aber auch Laserstrahlung. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der photopolymerisierbaren Schicht auf dem Träger zurückbleiben.

Die folgenden Beispiele erläutern bevorzugte Ausführungsformen der Erfindung. Mengenverhältnisse und Prozentzahlen sind in Gewichtseinheiten zu verstehen. Gewichtsteile (Gt) und Volumteile (Vt) stehen im Verhältnis von g zu ml.

Beispiel 1

Es wurden Beschichtungslösungen hergestellt aus:
66 Gt eines Polymerisats aus Methacrylsäure, Methylmethacrylat, Styrol und Butylacrylat (21:42:10:27),
34 Gt des Triacrylats eines alkoxylierten Trimethylolpropans (Laromer(R) 8748 der BASF),
0,5 Gt Phenylglycidylether,
1,0 Gt Leukokristallviolett und
0,05 Gt Viktoriareinblau FGA (C.I. Basic Blue 81)
in
135 Gt Butanon und
80 Gt Ethanol.

Jeder der so erhaltenen Stammlösungen wurde einer der folgenden Photoinitiatorzusätze einverleibt:
a) 0,5 Gt 1,3,5-Triphenyl-pyrazolin
b) 0,5 Gt 1,3,5-Triphenyl-pyrazolin und 1,0 Gt Benzanthron
c) 0,5 Gt 1,3,5-Triphenyl-pyrazolin und 1,0 Gt 1,2-Benzo-9,10-anthrachinon
d) 0,5 Gt 1,3,5-Triphenyl-pyrazolin und 1,0 Gt Fluorenon
e) 0,5 Gt 1,3,5-Triphenyl-pyrazolin und 1,0 Gt Triphenylsulfonium-tetrafluoroborat
f) 0,5 Gt 1,3,5-Triphenyl-pyrazolin und 1,0 Gt Diphenyljodonium-chlorid
g) 0,5 Gt 1,3,5-Triphenyl-pyrazolin und 1,0 Gt Triphenylsulfonium-hexafluorophosphat
h) 0,5 Gt 1,3,5-Triphenyl-pyrazolin und 1,0 Gt 2,2'-Bis-(o-chlorphenyl)-4,4',5,5'-tetraphenyl-bisimidazol

Die Lösungen wurden auf biaxial verstreckte und thermofixierte Polyethylenterephthalatfolien von 25 µm Stärke so aufgebracht, daß nach dem Trocknen bei 100 °C jeweils ein Schichtgewicht von 45 g/$m^2$ erhalten wurde.

Um die Trockenresistschichten vor Verschmutzung durch Staub und vor Beschädigungen zu schützen, wurden sie mit einer 23 µm starken Deckfolie aus Polyethylen kaschiert und aufgerollt. Danach können sie über einen längeren Zeitraum unter Lichtausschluß gelagert werden.

Proben der erhaltenen Trockenresistfolien wurden in einer handelsüblichen Laminiervorrichtung bei 115 °C auf mit 35 µm starker Kupferfolie kaschierte Phenoplast-Schichtstoffplatten laminiert und mittels einer 5-kW-Metallhalogenidlampe im Abstand von 110 cm zwischen Lampe und Vakuumkopierrahmen 8 bzw. 64 Sekunden belichtet. Als Vorlage diente ein 13-stufiger Belichtungskeil mit Dichteinkrementen von 0,15. Nach der Belichtung wurden die Polyesterfolien abgezogen und die Schichten mit 1 %iger Natriumcarbonatlösung in einem Sprühentwicklungsgerät innerhalb 60 s entwickelt.

In der folgenden Tabelle ist die Anzahl der gehärteten Keilstufen notiert:

| Probe | Belichtungszeit (Sekunden) | |
|---|---|---|
| | 8 | 64 |
| a | 0 | 0 |
| b | 1 | 8 |
| c | 0 | 3 |
| d | 1 | 8 |
| e | 0 | 2 |
| f | 0 | 1 |
| g | 0 | 2 |
| h | 7 | 13 |

Nur der Resist h entspricht den Anforderungen, die heute an ein Produkt gestellt werden.

Beispiel 2

Zu je 1 Gt
a 2-p-Dimethylaminophenyl-benzoxazol,
b 2-p-Diethylaminophenyl-benzoxazol,
c 2,5-Bis-p-diethylaminophenyl-1,3,4-oxdiazol,
d 1,3,5-Triphenyl-pyrazolin,
e 1,5-Diphenyl-3-styryl-pyrazolin
wurden 1000 Vt 2 molarer Schwefelsäure gegeben. c ging sofort in Lösung; a, b, d und e wurden 2 Stunden gerührt. a und b gingen zum größeren Teil mit hellgelber Farbe in Lösung, d und e blieben ungelöst. Nach dem Filtrieren wurden mit einem UV-Spektrometer (Perkin-Elmer Lambda 3) UV-Spektren der Lösungen zwischen 250 und 450 nm aufgenommen. Die Lösungen a und b zeigten zwischen 390 und 360 nm sowie unterhalb 340 nm in einer Schichtdicke von 1 cm eine Absorption von mehr als 3, die Lösung c unterhalb 305 nm eine Absorption von mehr als 3. Die Absorption der Flüssigkeiten d und e war dagegen im gesamten Wellenbereich kleiner als 0,01. Verdünnt man die Lösungen a bis c mit 2 m $H_2SO_4$ im Verhältnis 1 : 100, so zeigen die erhaltenen Lösungen a' und b' ein Absorptionsmaximum bei 295 nm (Absorption 0,5), die Lösung c' ein Maximum bei 280 nm (Absorption 0,85).

Beispiel 3

Zu Lösungen aus jeweils
66 Gt eines Polymerisats aus Methacrylsäure, Methylmethacrylat, Styrol und Butylacrylat (21:41:5:33),
20,4 Gt des Triacrylats von ethoxyliertem Trimethylolpropan,
6,8 Gt des Diurethans aus 2 mol Hydroxyethylacrylat und 1 mol 2,2,4-Trimethyl-hexamethylendiisocyanat,
6,8 Gt des Umsetzungsprodukts aus 1 mol Hydroxyethylacrylat, 4 mol Ethylenoxid und 1 mol n-Butylisocyanat,
1 Gt Leukokristallviolett,
0,1 Gt des Esters aus Decandisäure (Sebacinsäure) und 1,2,2,6,6-Pentamethyl-4-hydroxy-piperidin,
0,2 Gt des löslichen Phthalocyaninfarbstoffs Neozaponblau 807 (C.I. 74400) und
2 Gt 2,2'-Bis-(o-chlorphenyl)-4,4',5,5'-tetraphenyl-bisimidazol in
172 Gt Butanon und
45 Gt Ethanol
wurden jeweils 0,2 Gt der im Beispiel 2 genannten Coinitiatoren a bis e gegeben.

Die erhaltenen Lösungen 3a bis 3e wurden wie im Beispiel 1 beschrieben auf Polyethylenterephthalatfolie aufgebracht und getrocknet (Schichtgewicht 45 $g/m^2$).

Die Trockenresistfolien wurden dann auf 10 x 10 cm große Glasplatten laminiert und 8 Sekunden unter einer Vorlage mit 150 µm breiten Linien und 75 µm breiten transparenten Zwischenräumen belichtet und dann durch Besprühen mit 1 %iger Sodalösung entwickelt.

Die Glasplatten, deren Oberfläche zu 33 % mit feinen Resistbahnen belegt war, wurden nun in Küvetten mit je 25 ml 2-molarer Schwefelsäure gestellt. Nach 2 Stunden wurden aus den Küvetten Proben der Schwefelsäure entnommen und ihr UV-Spektrum aufgenommen.

Die Proben a und b zeigten eine deutliche Absorption bei 295 nm, die Probe c eine solche bei 280 nm, die Proben d und e dagegen keine zusätzliche Absorption gegen reine 2-molare Schwefelsäure. Demnach sind die Resists 3d und 3e gegen saure Galvanobäder unempfindlicher und verunreinigen diese nicht oder nur geringfügig.

Beispiel 4

Beschichtungslösungen aus
50 Gt eines Copolymerisats aus Methylmethacrylat und Methacrylsäure (Säurezahl 115),
50 Gt Trimethylolpropantriacrylat,
0,1 Gt Kristallviolett,
1,5 Gt Leukokristallviolett,
5 Gt 2,2'-Bis-(o-chlorphenyl)-4,4'5,5'-tetraphenylbisimidazol,
3 Gt Mercaptobenzthiazol und
4a) 2,5 Gt 1,3-Diphenyl-pyrazolin oder
4b) 2,5 Gt 1-Phenyl-3-(4-methylstyryl)-5-(4-methylphenyl)-pyrazolin in
800 Gt Butanon
wurden auf elektrolytisch aufgerauhtes und durch Anodisierung gehärtetes 0,3 mm starkes Aluminium durch Aufschleudern aufgetragen. Die Schicht wurde 2 Minuten bei 100 °C getrocknet, wobei man ein Schichtgewicht von 2,8 g/m$^2$ erhielt.

Die lichtempfindlich beschichteten Platten wurden mit einer 15-%igen wäßrigen Lösung von Polyvinylalkohol (12 % Restacetylgruppen, K-Wert 4) überzogen und zu einer Deckschicht von 4 bis 5 g/m$^2$ getrocknet.

Die so erhaltenen Druckplatten wurden mit einer 2-kW-Metallhalogenidlampe 1 Sekunde in einem Abstand von 100 cm unter einer Negativvorlage belichtet.

Die durch Licht nicht gehärteten Teile wurden durch Überwischen mit einer Entwicklerlösung folgender Zusammensetzung entfernt:
3 Gt Natriummetasilikat x 9 $H_2O$,
0,05 Gt Strontiumchlorid,
0,03 Gt nichtionogenes Netzmittel (Kokosfettalkohol-Polyoxyethylenether mit ca. 8 Oxyethyleneinheiten) und
0,003 Gt Antischaummittel in
100 Gt vollentsalztem Wasser.

Sowohl mit dem Muster 4a als auch mit 4b erhielt man leistungsfähige auflagenstarke Druckplatten.

Beispiel 5

Eine Lösung aus
54 Gt eines Polymeren aus 99 % Methylmethacrylat und 1 % Acrylsäure,
6,5 Gt o/p-Toluolsulfonamid,
0,4 Gt Leukokristallviolett,
2 Gt 2,2'-Bis-(o-chlorphenyl)-4,4',5,5'-tetraphenyl-bisimidazol,
0,1 Gt 1-Phenyl-5-(4'-methylphenyl)-3-(2-naphthyl)-pyrazolin,
0,5 Gt N-Phenylglycin,
0,5 Gt eines chlorierten Kupferphthalocyanins (C.I. Pigment Green 7),
3 Gt Triethylenglykoldiacetat und
33 Gt des Esters aus 1 mol Butan-1,4-bisglycidylether und 2 mol Acrylsäure in
150 Gt Aceton
wurde wie im Beispiel 1 auf eine biaxial verstreckte und thermofixierte Polyethylenterephthalatfolie von 25 µm Stärke so aufgebracht, daß nach dem Trocknen bei 100 °C ein Schichtgewicht von 54 g/m$^2$ erhalten wurde. Die Trockenresistfolie wurde in einer handelsüblichen Laminiervorrichtung bei 115 °C auf eine mit 35 µm starker Kupferfolie kaschierte Phenoplast-Schichtstoffplatte laminiert und mittels einer 5-kW-Metallhalogenidlampe im Abstand von 110 cm zwischen Lampe und Vakuumkopierrahmen 9 Sekunden belichtet. Als Vorlage diente eine Strichvorlage mit 50 µm breiten Linien und 50 µm Abständen. Nach der Belichtung wurde die Polyesterfolie abgezogen und die Schicht mit 1,1,1-Trichlorethan in einem Sprühentwicklungsgerät innerhalb 60 s entwickelt.

Man erhielt eine vorzügliche Wiedergabe der feinen Linien, d. h. der Resist zeichnet sich durch eine sehr gute Auflösung aus.

**Patentansprüche**

1. Photopolymerisierbares Gemisch, das als wesentliche Bestandteile
   a) ein polymeres Bindemittel,
   b) eine polymerisierbare Verbindung mit mindestens einer endständigen ethylenischen Doppelbindung und einem Siedepunkt oberhalb 100 °C bei Normaldruck,
   c) ein Hexaarylbisimidazol und
   d) einen weiteren Photoinitiator

   enthält, dadurch gekennzeichnet, daß der weitere Photoinitiator ein 1,3-Diaryl- oder ein 1-Aryl-3-aralkenylpyrazolin ist.

2. Gemisch nach Anspruch 1, dadurch gekennzeichnet, daß das pyrazolin der allgemeinen Formel I entspricht

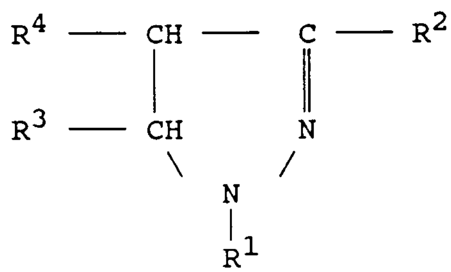

(I)

   worin
   $R^1$ ein 1- bis 3-kerniger Arylrest,
   $R^2$ ein Rest der Bedeutung von $R^1$ oder ein Aralkenylrest,
   $R^3$ ein Wasserstoffatom, ein Alkylrest oder ein Rest der Bedeutung von $R^1$ und
   $R^4$ ein Wasserstoffatom oder ein Alkylrest ist.

3. Gemisch nach Anspruch 2, dadurch gekennzeichnet, daß es eine Verbindung der Formel I enthält, worin $R^2$ ein ggf. substituierter Phenyl- oder Styrylrest ist.

4. Gemisch nach Anspruch 2, dadurch gekennzeichnet, daß es eine Verbindung der Formel I enthält, worin $R^1$ ein ggf. substituierter Phenylrest ist.

5. Gemisch nach Anspruch 1, dadurch gekennzeichnet, daß es 0,01 bis 10 Gew.-%, bezogen auf die Menge an polymerisierbarer Verbindung (b), an Pyrazolinverbindung enthält.

6. Gemisch nach Anspruch 1, dadurch gekennzeichnet, daß es 0,1 bis 20 Gew.-%, bezogen auf die Menge an polymerisierbarer Verbindung (b), an Hexaarylbisimidazol enthält.

7. Gemisch nach Anspruch 2, dadurch gekennzeichnet, daß es 20 bis 90 Gew.-% Bindemittel (a) und 10 bis 80 Gew.-% polymerisierbare Verbindung (b), bezogen auf die Gesamtmenge an a und b, enthält.

8. Gemisch nach Anspruch 1, dadurch gekennzeichnet, daß es zusätzlich einen Leukofarbstoff enthält.

9. Gemisch nach Anspruch 1, dadurch gekennzeichnet, daß die polymerisierbare Verbindung (b) ein Acryl- oder Methacrylsäureester ist.

**10.** Photopolymerisierbares Aufzeichnungsmaterial mit einem Schichtträger und einer photopolymerisierbaren Schicht, dadurch gekennzeichnet, daß die Schicht aus einem Gemisch gemäß einem der Ansprüche 1 bis 9 besteht.

## Claims

**1.** Photopolymerizable mixture which contains, as essential components,
a) a polymeric binder,
b) a polymerizable compound having at least one terminal ethylenic double bond and a boiling point above 100 °C at atmospheric pressure,
c) a hexaarylbisimidazole and
d) a further photoinitiator,
characterized in that the further photoinitiator is a 1,3-diaryl- or a 1-aryl-3-aralkenylpyrazoline.

**2.** Mixture according to Claim 1, characterized in that the pyrazoline corresponds to the general formula I

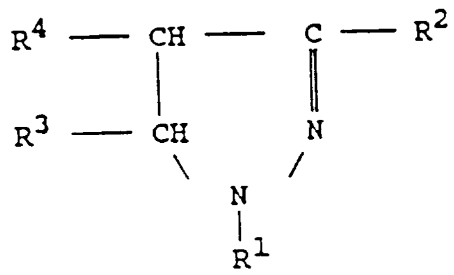

(I)

in which
$R^1$ is a mononuclear to trinuclear aryl radical,
$R^2$ is a radical having the meaning of $R^1$ or an aralkenyl radical,
$R^3$ is a hydrogen atom, an alkyl radical or a radical having the meaning of $R^1$ and
$R^4$ is a hydrogen atom or an alkyl radical.

**3.** Mixture according to Claim 2, characterized in that it contains a compound of the formula I in which $R^2$ is an optionally substituted phenyl or styryl radical.

**4.** Mixture according to Claim 2, characterized in that it contains a compound of the formula I in which $R^1$ is an optionally substituted phenyl radical.

**5.** Mixture according to Claim 1, characterized in that it contains 0.01 to 10% by weight, based on the amount of polymerizable compound (b), of a pyrazoline compound.

**6.** Mixture according to Claim 1, characterized in that it contains 0.1 to 20% by weight, based on the amount of polymerizable compound (b), of hexaarylbisimidazole.

**7.** Mixture according to Claim 2, characterized in that it contains 20 to 90% by weight of binder (a) and 10 to 80% by weight of polymerizable compound (b), based on the total amount of a and b.

**8.** Mixture according to Claim 1, characterized in that it additionally contains a leuco dye.

**9.** Mixture according to Claim 1, characterized in that the polymerizable compound (b) is an acrylate or methacrylate.

**10.** Photopolymerizable recording material having a substrate and a photopolymerizable layer, characterized in that the layer consists of a mixture according to any of Claims 1 to 9.

## Revendications

**1.** Mélange photopolymérisable, qui contient comme constituants essentiels
a) un liant polymère,
b) un composé polymérisable ayant au moins une double liaison éthylénique terminale et un point d'ébullition supérieur à 100 °C sous la pression normale,
c) un hexaarylbisimidazole et
d) un autre photoinitiateur,
caractérisé en ce que l'autre photoinitiateur est une 1,3-diaryl- ou une 1-aryl-3-aralcénylpyrazoline.

**2.** Mélange selon la revendication 1, caractérisé en ce que la pyrazoline répond à la formule générale I :

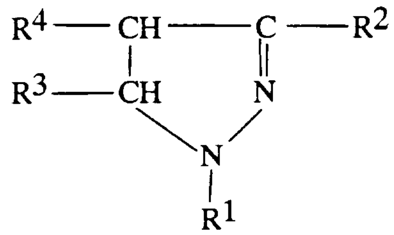

(I)

dans laquelle
$R^1$ est un reste aryle ayant 1 à 3 noyaux,
$R^2$ est un reste ayant la signification de $R^1$ ou un reste aralcényle,
$R^3$ est un atome d'hydrogène, un reste alkyle ou un reste ayant la signification de $R^1$ et
$R^4$ est un atome d'hydrogène ou un reste alkyle.

**3.** Mélange selon la revendication 2, caractérisé en ce qu'il contient un composé de formule I, dans laquelle $R^2$ est un reste phényle ou styryle éventuellement substitué.

**4.** Mélange selon la revendication 2, caractérisé en ce qu'il contient un composé de formule I, dans laquelle $R^1$ est un reste phényle éventuellement substitué.

**5.** Mélange selon la revendication 1, caractérisé en ce qu'il contient 0,01 à 10 % en poids de dérivé de pyrazoline, par rapport à la quantité du composé polymérisable (b).

**6.** Mélange selon la revendication 1, caractérisé en ce qu'il contient 0,1 à 20 % en poids d'hexaarylbisimidazole, par rapport à la quantité du composé polymérisable (b).

**7.** Mélange selon la revendication 2, caractérisé en ce qu'il contient 20 à 90 % en poids du liant (a) et 10 à 80 % en poids du composé polymérisable (b), par rapport à la quantité totale de (a) et (b).

**8.** Mélange selon la revendication 1, caractérisé en ce qu'il contient en outre un colorant leuco.

**9.** Mélange selon la revendication 1, caractérisé en ce que le composé polymérisable (b) est un ester acrylique ou méthacrylique.

**10.** Matériau de reproduction photopolymérisable ayant un support de couche et une couche photopolymérisable, caractérisé en ce que la couche consiste en un mélange selon l'une des revendications 1 à 9.